# EUROPEAN PATENT APPLICATION

(11) **EP 4 683 455 A1**
(43) Date of publication of application: **21.01.2026**
(21) Application number: 24189687.7
(22) Date of filing: 19.07.2024
(51) Int. Cl.: H10D 30/47

(54) **A METHOD FOR PRODUCING A III-NITRIDE TRANSISTOR**

(71) Applicant: Imec VZW, 3001 Leuven (BE); Katholieke Universiteit Leuven KU Leuven Research & Development, 3000 Leuven (BE)
(72) Inventor: Bagal, Indrajit Vijay, 3001 Heverlee (BE); Chancerel, Francois, 1000 Brussel (BE); Vermeersch, Bjorn, 3001 Heverlee (BE); Peralagu, Uthayasankaran, 3001 Heverlee (BE)
(74) Representative: Patent Department IMEC

(57) **Abstract**

**A METHOD FOR PRODUCING A III-NITRIDE TRANSISTOR**

A heat spreading layer (10) is formed directly on a layer stack, including a III-nitride channel layer (3) and a III-nitride barrier layer (4), produced on a first carrier substrate (1). A wafer transfer step is then performed, wherein the first carrier substrate (1) is attached to a second carrier substrate (12) by bonding the heat spreading layer directly or indirectly to the second carrier substrate, followed by the removal of the first carrier substrate and possibly a number of the III-nitride layers of the stack, selectively with respect to the active layers, and by the formation of source, drain and gate terminals (20-22) of the transistor. The heat spreading layer is thereby close to the active layers of the transistor, enabling efficient heat removal from the 2DEG channel in said transistor.

## Description

### Field of the Invention

The present invention is related to the production of III-nitride based semiconductor transistors, such as GaN-based High Electron Mobility Transistors (HEMT).

### State of the art.

III-nitride transistors are based on the formation of high mobility charge carriers near the interface between a channel layer and a barrier layer formed of different III-nitride materials having specific intrinsic characteristics in terms of their crystal structure. A well-known combination is a GaN channel layer with an AlGaN barrier layer. Because the effects of the spontaneous and piezo-electric polarizations occurring within the crystal structures of the materials, a so-called 2DEG (2-dimensional electron gas) is formed in the channel layer, at the interface between the channel layer and the barrier layer, exhibiting high electron mobility in the plane of the 2DEG. The thermal management of III-nitride transistors is however challenging due to the impact of self-heating of the 2-dimensional electron gas.

### Summary of the invention

The invention is related to a method and a transistor in accordance with the appended claims. According to the invention, a heat spreading layer is formed directly on a layer stack, including a III-nitride channel layer and a III-nitride barrier layer, produced on a first carrier substrate. A wafer transfer step is then performed, wherein the first carrier substrate is attached to a second carrier substrate by bonding the heat spreading layer directly or indirectly to the second carrier substrate, followed by the removal of the first carrier substrate and possibly a number of the III-nitride layers of the stack, selectively with respect to the active layers, and by the formation of source, drain and gate terminals of the transistor. The heat spreading layer is thereby close to the active layers of the transistor, enabling efficient heat removal from the 2DEG channel in said transistor.

The invention is in particular related to a method for producing a transistor, comprising the steps of :
- providing a first carrier substrate,
- by epitaxial growth, producing on said first carrier substrate a layer stack comprising at least, at the top of the stack, a III-nitride channel layer having a bottom side and a top side and a III-nitride barrier layer on the top side of the channel layer,
- producing a heat spreading layer on said stack,
- thereafter, attaching the first carrier substrate including the layer stack and the heat spreading layer to a second carrier substrate, by bonding the heat spreading layer directly or indirectly to said second carrier substrate,
- thereafter, removing the first carrier substrate selectively with respect to the channel layer and the barrier layer,
- thereafter, producing source, drain and gate terminals of the transistor in contact with thechannel layer.

According to an embodiment, the heat spreading layer is produced directly on the barrier layer

According to an embodiment, the heat spreading layer is bonded indirectly to the second carrier substrate by depositing a first bonding layer on the heat spreading layer and bonding said first bonding layer to a second bonding layer formed on the second carrier substrate.

According to an embodiment, the first and second bonding layers are formed of the same material.

According to an embodiment, the heat spreading layer is bonded directly to the second carrier substrate by bonding said heat spreading layer to a bonding layer formed on the second carrier substrate.

According to an embodiment, the bonding layer formed on the second carrier substrate is formed of the same material as the heat spreading layer.

According to an embodiment, the channel layer is formed of GaN and said epitaxial growth is configured to grow Ga-polar GaN on the first carrier substrate so that the bottom side of the channel layer is formed of N-polar GaN.

According to an embodiment, the material of the heat spreading layer is chosen from the group consisting of : AlN, SiC, AlGaN, hBN, GaN, diamond, graphene.

According to an embodiment, the step of removing the first carrier substrate is done by a method that enables the re-use of the first carrier substrate.

The invention is also related to a transistor comprising :
- a carrier substrate,
- a heat spreading layer bonded to the carrier substrate,
- a stack of active III-nitride layers directly on the heat spreading layer,
- source, drain and gate terminals on the stack of active III-nitride layers.

According to an embodiment of the transistor, the heat spreading layer is attached directly to the carrier substrate, i.e. without any bonding layers between said heat spreading layer and the carrier substrate.

According to an embodiment of the transistor, the heat spreading layer is attached indirectly to the carrier substrate, i.e. bonded to said carrier substrate by bonding layers formed of a material other than the material of the heat spreading layer.

According to an embodiment of the transistor, the active layers comprise a barrier layer directly on the heat spreading layer and a channel layer on the barrier layer.

According to an embodiment of the transistor, the channel layer is formed of GaN and the source, drain and gate terminals are in contact with an N-polar side of the GaN channel layer.

### Brief description of the figures

Figures 1 to 7 illustrate the method of the invention according to a first embodiment.
Figures 8 to 11 illustrate the method of the invention according to a second embodiment.

### Detailed description of the invention

The invention will be described in more detail on the basis of two embodiments. The invention is however not limited to these particular embodiments.

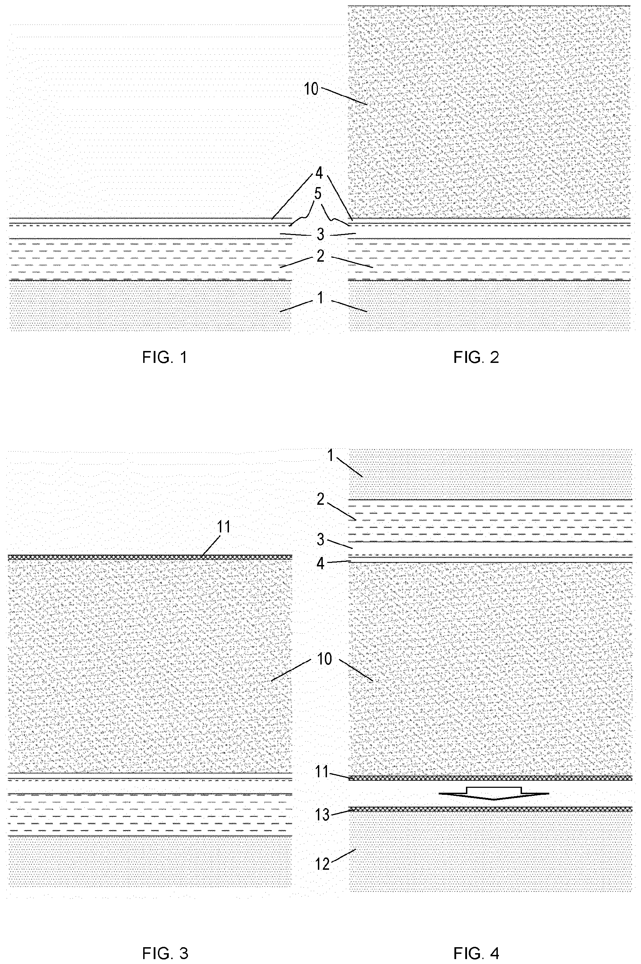

With reference to Figure 1, a first carrier substrate 1 is provided and a stack of III-nitride materials is formed on the first carrier substrate 1 by epitaxial growth. In the first embodiment, this stack includes a buffer layer 2 and active layers 3 and 4.

The first carrier substrate 1 may be any substrate suitable for producing thereon a III-nitride transistor (defined herein as a transistor comprising a channel layer and a barrier layer formed of III-nitride materials). Well known examples thereof include silicon, silicon carbide or sapphire substrates. The buffer layer 2 may be structured according to any known buffer design. The main purpose of the buffer layer 2 is to alleviate the effects of the mismatch between the lattice constants of the first carrier substrate 1 and the active layers 3 and 4. The buffer layer 2 may for example comprise an AlN nucleation layer grown on a silicon first carrier substrate 1, and a stack of AlGaN layers with stepwise decreasing Al-concentration.

In the illustrated embodiment, the active layers comprise a GaN channel layer 3 which may be an intrinsic GaN layer, and an AlGaN barrier layer 4. An intrinsic GaN layer is an epitaxially grown GaN layer that does not comprise intentionally added dopant elements. It is therefore a crystalline GaN layer having the typical crystal structure of crystalline GaN and comprising no dopant elements other than impurities unavoidably included in the structure during the epitaxial growth process, such as oxygen molecules, which do not influence the functionality of the transistor. The use of GaN and AlGaN for the channel and barrier layers is merely exemplary and other III-V materials are possible.

The barrier layer 4 is an AlGaN layer of a composition and thickness chosen so that a 2DEG (2-dimensional electron gas) 5 may be formed in the channel layer 3, near the interface between the channel layer 3 and the barrier layer 4. The 2DEG 5 is shown in the drawing, but it may be formed only in the operational transistor that is to be produced (see further), when the transistor is configured to conduct current. The combined thickness of the channel layer 3 and the barrier layer 4 may be within a wide range depending on the specific application. A combined thickness of active layers 3 and 4 between 10 and 100 nm is for example possible. For example, a 35 nm GaN channel layer 3 could be combined with a 10 nm thick AlGaN barrier layer 4. The barrier layer 4 may be formed directly on the channel layer 3, or a thin spacer layer could be formed between the two, for example a 1 nm AlN layer.

According to preferred embodiments, the top side of the GaN channel layer 3 is Ga-polar (also referred to as 'Ga-face'), referring to the crystal orientation of the GaN molecules. This is the most common orientation obtained for example when the epitaxial growth of GaN is performed on a (111) Si process wafer. This means that the bottom side of the GaN is N-polar (or 'N-face'). As the method of the invention involves a wafer transfer step, the eventual III-nitride transistor in that case is formed on the N-polar side of the channel layer 3, which is known to be advantageous in terms of the 2DEG confinement and the lower ohmic resistance between the channel and the gate, source and drain terminals of the transistor.

Methods for producing the III-nitride stack 2-3-4 on the first carrier substrate 1 are known as such, for example CVD (chemical vapour deposition) or MOCVD (metal organic vapour deposition), or a combination of known techniques..

With reference to Figure 2, a heat spreading layer 10 is produced on the barrier layer 4. The term 'heat spreading layer' is defined within the present context as a layer that is thermally conductive and capable of conducting heat away from the 2DEG in the operational III-nitride transistor. This requires a suitable combination of the material and the thickness of the heat spreading layer. Suitable materials include AlN, AlGaN, hBN (hexagonal boron nitride), SiC, diamond, GaN. Another suitable heat spreading layer may be formed as a stack of layers formed of a 2D material such as graphene. These materials may be formed on the barrier layer 4 by epitaxial growth, for example by applying the PECVD technique (plasma enhanced chemical vapour deposition). For example, when AlN is used as the heat spreading material, an AlN layer 10 of at least 400 nm thick may be formed by PECVD, on an AlGaN barrier layer 4.

The heat spreading layer 10 may be formed directly on the barrier layer 4, or a thin intermediate layer may be present, for example a GaN cap layer of about 3 nm could be formed on the barrier layer 4 prior to producing the heat spreading layer directly on the GaN cap layer.

With reference to Figure 3, a bonding layer 11 is deposited on the heat spreading layer 10. The bonding layer 11 is preferably a dielectric layer suitable for use in a direct dielectric-to-dielectric wafer level bonding technique. The bonding layer 11 may for example be a thin SiCN layer formed by PECVD followed by a planarization technique for obtaining a required degree of planarity of the bonding surface of the bonding layer 11. For example, a 100 nm SiCN layer may be formed by PECVD and planarized and thinned to a thickness of 80nm. Planarization can be done by a applying a suitable CMP recipe (chemical mechanical polishing). Optionally, the heat spreading layer 10 is planarized by CMP prior to depositing the bonding layer 11. The planarization may also thin the heat spreading layer. For example, a 700nm SiC layer formed by PECVD may be thinned and planarized to 500nm to form the final heat spreading layer. A second carrier substrate 12 is then provided, as illustrated in Figure 4. This may be a further Si process wafer 12 comprising a second SiCN planarized bonding layer 13 on its surface. By a SiCN-SiCN direct bonding technique, the first carrier substrate 1 is then attached to the second carrier substrate 12, i.e. by bonding the heat spreading layer 10 indirectly to the second carrier substrate 12. The term 'indirectly' refers to the fact that a bonding layer 11 is first formed on the heat spreading layer 10 prior to bonding said heat spreading layer to the second carrier substrate 12, equally provided with a bonding layer 13.

In the case of bonding the heat spreading layer 10 indirectly to the second carrier substrate 12, the bonding layers 11 and 13 (for example SiCN) typically have a thermal conductivity than can be lower by a factor of 10 or more compared to the heat spreading layer 10 (for example SiC), which may reduce the overall thermal performance of the N-polar HEMT. The impact of the bonding layer thickness on the thermal performance can be minimised by using a material with a very high thermal conductivity for the heat spreading layer 10 and with increasing the thickness of the heat spreading layer 10 (i.e. higher than the above-indicated example of about 500nm).

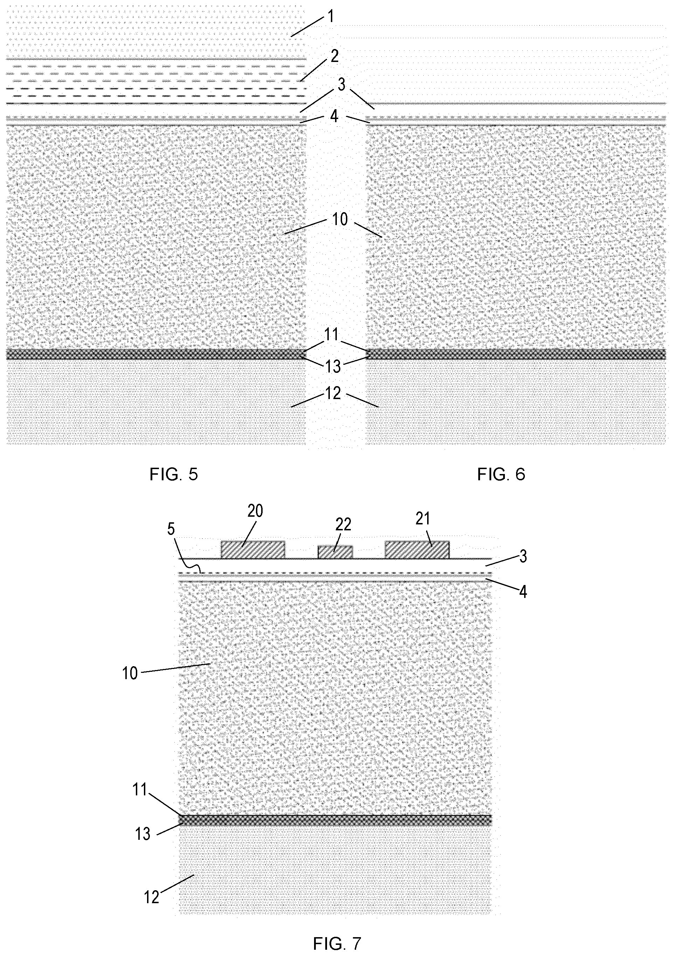

When the bond is established (as shown in Figure 5), the first carrier 1 substrate is removed, with reference to Figure 6. In the embodiment shown, the buffer layer 2 is also removed. Removing the first carrier substrate 1 and the buffer layer 2 can be done by grinding to remove the bulk of the carrier substrate 1, followed by plasma etching or wet etching. Possibly one or more layers could be present between the buffer layer 2 and the GaN channel layer 3, including an etch stop layer for enabling the selective removal of the buffer layer. Such an etch stop layer could for example be an AlGaN layer of about 15 nm thick. The etch stop layer itself can then be removed, or the etch stop layer and possibly further layers could remain on the bottom side of the channel layer 3 before initiating the next steps of the method.

Removal of the first carrier substrate 1 can alternatively be done in such a way that the substrate 1 can be re-used. This can be done by any number of substrate detachment methods known as such in the art, wherein a release layer is incorporated in the substrate 1 itself or in the stack of layers 2-4 produced on the substrate 1. A dopant implant layer in the substrate can for example enable the removal of the bulk of the substrate by the so-called smart cut technique. Or the incorporation of a release layer in the stack, for example between the substrate 1 and the buffer layer 2, can enable the removal by laser detachment or selective under-etching, or by peeling if the release layer is a low adhesion layer (for example formed of 2D materials). Layers remaining on the channel layer 3 after this type of substrate removal are then subsequently removed by etching until the bottom side of the channel layer 3 is exposed. After the detachment of the substrate 1, said substrate 1 is subjected to a number of treatment steps, such as wet or dry etching and CMP, before the substrate can be re-used. After the substrate removal step, source, drain and gate terminals 20,21,22 are produced in contact with the channel layer 3, as illustrated in Figure 7. The terminals are shown schematically on top of the channel layer 3, but they may be partly buried in the channel layer and/or buried in layers which remained on the channel layer 3 after the carrier substrate removal step. The terminals 20-22 form the contacts of a III-nitride transistor in accordance with the invention. Depending on the precise dimensions and materials used, the transistor may be a high electron mobility transistor (HEMT), or a III-nitride based metal-oxide-semiconductor field effect transistor (MOSFET). Contacting the transistor is enabled by forming a multilayer back end of line type interconnect structure (not shown) on top of the source, drain and gate terminals 20-22, in a manner known in the art. When the transistor is operational, the source terminal 20 is coupled to a ground or any other suitable reference voltage. The gate terminal 22 is coupled to a gate voltage, configured to modulate the 2DEG 5, while the drain terminal 21 is coupled to a source-drain voltage source.

As the heat spreading layer 10 is in close proximity to the active layers 4,3 of the transistor, heat produced by self-heating of the 2DEG is removed efficiently.

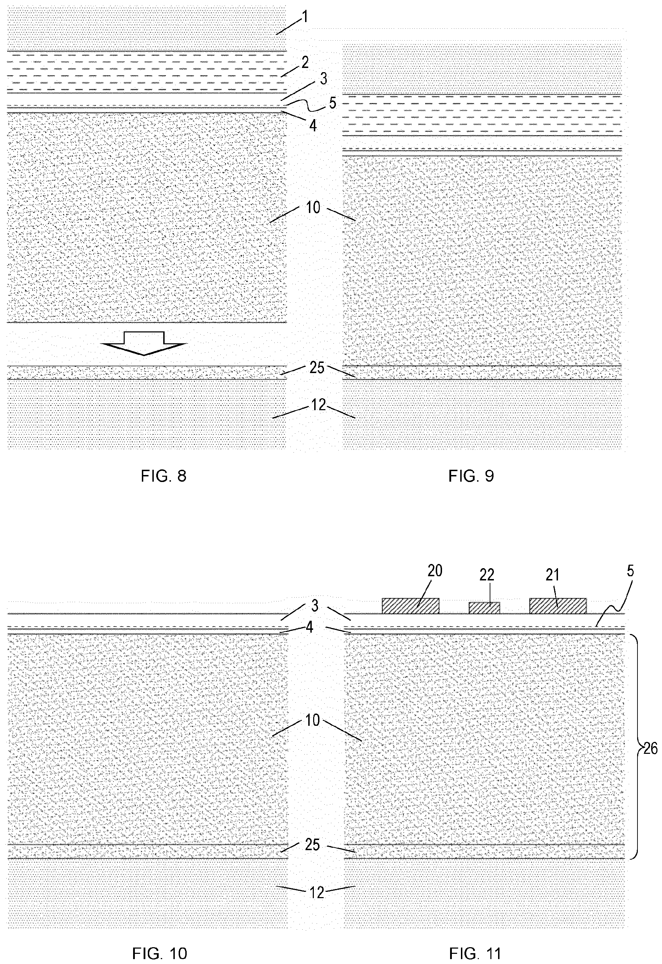

A second embodiment is illustrated with reference to Figures 8 to 11. The first carrier substrate 1 is now attached to the second carrier substrate 12 by bonding the heat spreading layer 10 directly to the second carrier substrate 12, 'directly' meaning that no bonding layer is formed on the heat spreading layer 10 prior to bonding. In the embodiment shown, a bonding layer 25 is however formed on the second carrier substrate 12. The bonding layer 25 is formed of the same material as the heat spreading layer, but its thickness is lower than the thickness of the heat spreading layer. Prior to bonding, planarization, e.g. by CMP, of the bonding surfaces of the heat spreading layer 10 and the bonding layer 25 is performed. For example, a 700 nm SiC heat spreading layer 10 on the first carrier substrate 1 can be planarized and thinned to 500nm, and a 100nm SiC bonding layer 25 on the second carrier substrate 12 can be planarized and thinned to 80 nm, prior to the bonding step.

The steps performed after bonding are illustrated in Figures 9 to 11 and these steps are the same as described for the first embodiment: removal of the first carrier substrate 1 and the buffer layer 2 selectively with respect to the active layers 3,4 (Figures 9-10) and formation of source, drain and gate terminals 20-22 (Figure 11). In the transistor obtained by the method according to this embodiment, the initial heat spreading layer 10 combined with the bonding layer 25 forms a final heat spreading layer 26, given that the material of the bonding layer is the same as the material of the initial heat spreading layer. The final heat spreading layer 26 is directly attached to the second carrier substrate 12 in this case. In the case of the first embodiment, the heat spreading layer 10 of the finished transistor is indirectly attached to the second carrier substrate, i.e. it is attached thereto through bonding layers 11,13 formed of a material other than the material of the initial heat spreading layer.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

Unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A method for producing a transistor, comprising the steps of :
- providing a first carrier substrate (1),
- by epitaxial growth, producing on said first carrier substrate a layer stack (2,3,4) comprising at least, at the top of the stack, a III-nitride channel layer (3) having a bottom side and a top side and a III-nitride barrier layer (4) on the top side of the channel layer (3),
- producing a heat spreading layer (10) on said stack,
- thereafter, attaching the first carrier substrate (1) including the layer stack (2,3,4) and the heat spreading layer (10) to a second carrier substrate (12), by bonding the heat spreading layer (10) directly or indirectly to said second carrier substrate (12),
- thereafter, removing the first carrier substrate (1) selectively with respect to the channel layer (3) and the barrier layer (4),
- thereafter, producing source, drain and gate terminals (20,21,22) of the transistor in contact with thechannel layer (3).

2. The method according to claim 1, wherein the heat spreading layer (10) is produced directly on the barrier layer (4).

3. The method according to claim 1 or 2, wherein the heat spreading layer (10) is bonded indirectly to the second carrier substrate (12) by depositing a first bonding layer (11) on the heat spreading layer (10) and bonding said first bonding layer (11) to a second bonding layer (13) formed on the second carrier substrate (12).

4. The method according to claim 3, wherein the first and second bonding layers (11,13) are formed of the same material.

5. The method according to claim 1 or 2, wherein the heat spreading layer (10) is bonded directly to the second carrier substrate (12) by bonding said heat spreading layer (10) to a bonding layer (25) formed on the second carrier substrate (12).

6. The method according to claim 5, wherein the bonding layer (25) formed on the second carrier substrate (12) is formed of the same material as the heat spreading layer (10).

7. The method according to any one of the preceding claims, wherein the channel layer (3) is formed of GaN and wherein said epitaxial growth is configured to grow Ga-polar GaN on the first carrier substrate (1), so that the bottom side of the channel layer (3) is formed of N-polar GaN.

8. The method according to any one of the preceding claims, wherein the material of the heat spreading layer (10) is chosen from the group consisting of : AlN, SiC, AlGaN, hBN, GaN, diamond, graphene.

9. The method according to any one of the preceding claims, wherein the step of removing the first carrier substrate (1) is done by a method that enables the re-use of the first carrier substrate.

10. A transistor comprising :
- a carrier substrate (12),
- a heat spreading layer (10,26) bonded to the carrier substrate (12),
- a stack of active III-nitride layers (4,3) directly on the heat spreading layer (10,26),
- source, drain and gate terminals (20,21,22) on the stack of active III-nitride layers.

11. The transistor according to claim 10, wherein the heat spreading layer (26) is attached directly to the carrier substrate (12), i.e. without any bonding layers between said heat spreading layer and the carrier substrate.

12. The transistor according to claim 11, wherein the heat spreading layer (10) is attached indirectly to the carrier substrate (12), i.e. bonded to said carrier substrate by bonding layers (11,13) formed of a material other than the material of the heat spreading layer (10).

13. The transistor according to any one of claims 10 to 12, wherein the active layers comprise a barrier layer (4) directly on the heat spreading layer (10,26) and a channel layer (3) on the barrier layer (4).

14. The transistor according to claim 13, wherein the channel layer (3) is formed of GaN and wherein the source, drain and gate terminals (20,21,22) are in contact with an N-polar side of the GaN channel layer.
